# EUROPEAN PATENT SPECIFICATION

(11) **EP 1 336 647 B1**
(45) Date of publication and mention of the grant of the patent: **23.08.2006**
(21) Application number: 03003142.1
(22) Date of filing: 13.02.2003
(51) Int. Cl.: C09J 7/02, H05K 3/00

(54) **Fixing adhesive sheet for flexible printed circuit board and method for mounting electronic parts in flexible printed circuit board**
Klebefolie für flexible bedruckte Leiterplatte sowie Verfahren zum Montieren elektronischer Teile auf eine flexible bedruckte Leiterplatte
Feuille adhésive pour plaquette à circuit imprimé flexible et procédé pour monter des composants électroniques sur une plaquette à circuit imprimé flexible

(30) Priority: 14.02.2002 JP 2002036817
(43) Date of publication of application: 20.08.2003
(73) Proprietor: NITTO DENKO CORPORATION, Osaka (JP)
(72) Inventor: Tanaka, Kazumasa, Ibaraki-shi, Osaka (JP); Muta, Shigeki, Ibaraki-shi, Osaka (JP); Yamamoto, Hiroshi, Ibaraki-shi, Osaka (JP); Yoshikawa, Takao, Ibaraki-shi, Osaka (JP)
(74) Representative: Grünecker, Kinkeldey, Stockmair & Schwanhäusser Anwaltssozietät

(56) References cited:
- EP-A- 0 622 833
- EP-A- 0 651 984
- EP-A- 1 072 664

## Description

The present invention relates to the use of an adhesive sheet useful for fixing a flexible printed circuit board (hereinafter referred to as "FPC" occasionally) to a fixing board (carrier board). More specifically, it relates to the use of an adhesive sheet through which an FPC can be easily attached/detached to/from a carrier board and which can be easily released from the carrier board even in the case where the adhesive sheet has been already used at least once. It also relates to a method for mounting electronic parts in an FPC by using the adhesive sheet.

Heretofore, various kinds of electronic parts (such as ICs, capacitors, etc.) can be mounted in a rigid board (such as a glass board or an epoxy board) automatically by use of a mounting machine [e.g., PANASERT (made by Matsushita Electric Industrial Co., Ltd.)] at the time of production of an electronic circuit board. Because positional accuracy of the rigid board is important in the mounting method when electronic parts are mounted, the rigid board is generally carried in the condition that the rigid board is clamped by carrier rails so as to be prevented from moving.

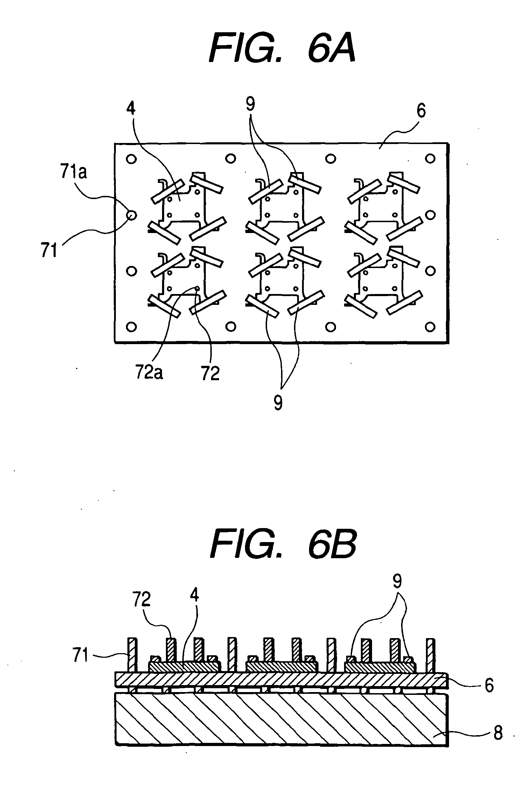

On the other hand, reduction in size and weight of electronic appliances has advanced in recent years. For this reason, electronic parts may be mounted (surface-mounted) directly in a surface of a flexible printed circuit board (FPC). Positional accuracy of the FPC is low because the FPC (board) itself is so flexible that the FPC cannot be fixed firmly even in the case where the FPC is clamped by carrier rails. Therefore, for example, the FPC is fixed to a carrier board by a method shown in Figs. 6A and 6B before electronic parts are mounted in the FPC. Figs. 6A and 6B are schematic views showing a typical example of the related-art FPC fixing method. In Figs. 6A and 6B, the reference numeral 4 designates FPCs; 6, a mother board (fixing board or carrier board); 71, mother board-fixing guide pins; 72, FPC-positioning guide pins; 71a, holes for inserting the mother board-fixing guide pins 71; 72a, holes for inserting the FPC-positioning guide pins 72; 8, a fixing table; and 9, adhesive tapes. The method shown in Figs. 6A and 6B is as follows. The FPCs 4 are mounted on the surface of the mother board 6 (such as an aluminum board) while the FPC-positioning guide pins 72 are fitted into the holes 72a provided in the FPCs 4. The FPCs 4 are stuck and fixed, from above the FPCs 4, onto the mother board 6 at about 2 to 4 points per FPC by the adhesive tapes 9 (e.g., pressure-sensitive adhesive tapes conventionally used such as adhesive tapes each of which has a polyimide film or a fluororesin-based film as a base, and a pressure-sensitive adhesive layer formed on a single surface of the base). Then, the mother board 6 is fixed to the carrier fixing table 8 while the mother board-fixing guide pins 71 are fitted into the holes 71a provided in the mother board 6. In the condition that the fixing table 8 is clamped by carrier rails, electronic parts are mounted in the FPCs 4.

A method of fixing a liquid pressure-sensitive adhesive solution directly applied or sprayed on a carrier board (fixing board) and fixing FPCs on the carrier board is also used.

When each FPC is fixed to the carrier board in the related-art electronic parts mounting process as shown in Figs. 6A and 6B, however, adhesive tapes for fixing corners of the FPC are provided in about 2 to 4 places and narrow adhesive tapes per FPC are further provided in several places. Hence, much labor and time are required for attaching/detaching the FPC, so that workability is low. In addition, because the pressure-sensitive adhesive component may remain on the FPC, it can be hardly said that the process is efficient.

Therefore, a method of sticking an adhesive sheet onto a carrier board and then fixing FPCs onto the adhesive sheet may be conceived. In the electronic parts mounting process, however, a heating process such as an infrared heating (IR heating) process is required for melting solder. Hence, the temperature at which the FPCs are released from the carrier board varies, for example, in a range of from room temperature to about 200°C which is a temperature just after the IR heating process (IR reflow process) . In this case, though the adhesive sheet exhibits good fixing characteristic (tackiness) and good release characteristic (releasability) at the ordinary temperature, there is the possibility that the adhesive sheet is softened or hardened due to deformation or deterioration at a high temperature (e.g., a high temperature just after IR heating). When, for example, the adhesive sheet is softened so that each FPC is released from the adhesive sheet, the pressure-sensitive adhesive component may remain on the FPC (i.e., adhesive may remain). When, for example, the adhesive sheet is hardened, there may occur the phenomenon that each FPC drops out at the time of IR heating.

Incidentally, it is preferable that both fixation of FPCs in the IR reflow process and release of the FPCs after the IR reflow process can be performed well, and that the adhesive sheet can be released from the carrier board easily without breaking or tearing after the adhesive sheet has been already used.

Because the temperature of the heating line in the heating process (e.g., IR reflow process) becomes very high, a material not deformed or deteriorated in the heating process is preferably used as the base in the adhesive sheet.

Therefore, an object of the invention is to provide a flexible printed circuit board-fixing adhesive sheet which facilitates sticking/release of each flexible printed circuit board to/from a carrier board and which has a pressure-sensitive adhesive layer that can be restrained or prevented from being deformed or deteriorated even in the case where the adhesive sheet is heated when electronic parts are mounted in each flexible printed circuit board, and to provide a method using the adhesive sheet for mounting electronic parts in each flexible printed circuit board.

Another object of the invention is to provide a flexible printed circuit board-fixing adhesive sheet in which: each FPC can be attached/detached to/from a carrier board with excellent workability when electronic parts are mounted in each FPC; each FPC can be prevented from dropping out from the pressure-sensitive adhesive layer of the adhesive sheet after a heating process; and the adhesive sheet itself can be released from the carrier board easily without breaking while no pressure-sensitive adhesive component remains on each FPC after the release, and to provide a method using the adhesive sheet for mounting electronic parts in each flexible printed circuit board.

A further object of the invention is to provide a flexible printed circuit board-fixing adhesive sheet in which electronic parts can be mounted in each FPC with high accuracy in addition to the aforementioned characteristic, and a method using the adhesive sheet for mounting electronic parts in each flexible printed circuit board.

The inventors have made an examination eagerly to achieve the foregoing objects. As a result, it has been found that when an adhesive sheet having a base, and a pressure-sensitive adhesive layer which is formed on at least one surface of the base and which is made of an acrylic-based pressure-sensitive adhesive composition containing a specific acrylic-based copolymer and a specific crosslinker is used, both adhesion and releasability of the adhesive sheet are kept excellent even after a heating process at the time of mounting electronic parts in each FPC as well as there is no adhesive component remaining on the FPC after release while both adhesion of the FPC to a carrier board and releasability of the FPC from the carrier board can be retained. Thus, the invention has been accomplished.

That is, according to the invention, there is provided the use of an adhesive sheet, said adhesive sheet comprising:
a base; and
a pressure-sensitive adhesive layer formed on at least one surface of said base and including an acrylic-based copolymer, and an aluminum-based chelate crosslinker which includes an aluminum chelate compound constituted by aluminum and a chelating agent capable of acting on aluminum to form a chelate ring, said acrylic-based copolymer containing (meth)acrylic alkyl ester having an alkyl group with 4 to 14 carbon atoms as a main monomer component and containing a functional group in one molecule, said functional group being derived from a functional group contained in a functional group-containing copolymerizable monomer as a copolymerizable monomer component, wherein a ratio of an amount of said functional group-containing copolymerizable monomer to a total amount of monomer components is selected to be in a range of from 0.1 % by weight to 10 % by weight,
for fixing a flexible printed circuit board to a carrier board when electronic parts are mounted on a surface of said flexible printed circuit board.

Preferably, the base is a heat-resistant film allowed to be used continuously at a temperature of not lower than 100°C.

The invention includes a method of mounting electronic parts in a flexible printed circuit board, including the steps of: fixing a flexible printed circuit board to a carrier board by a flexible printed circuit board-fixing adhesive sheet defined above; and mounting electronic parts in a surface of the flexible printed circuit board.
Fig. 1A is a schematic top view showing a state in which FPCs are stuck to a carrier board by use of an adhesive sheet used according to the invention; and Fig. 1B is a schematic side view showing this state;
Fig. 2 is a sectional view showing an example of the adhesive sheet used according to the invention;
Fig. 3 is a sectional view showing another example of the adhesive sheet used according to the invention;
Fig. 4 is a graph showing the IR reflow temperature condition;
Fig. 5 is a schematic view showing the configuration of an FPC sample in evaluation of IR reflow retention; and
Figs. 6A and 6B are schematic views showing a typical example of the related-art FPC-fixing method.

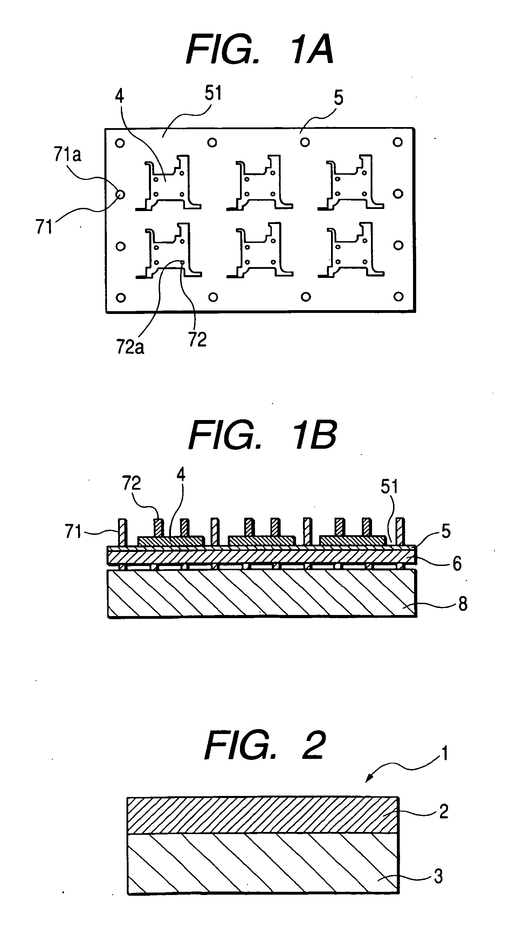

An embodiment of the invention will be described below by referring to the drawings in accordance with necessity. Figs. 1A and 1B are schematic views showing an example of the method for mounting electronic parts in each FPC according to the invention. Specifically, Fig. 1A is a schematic top view showing an example of the state in which FPCs are stuck to a carrier board, and Fig. 1B is a schematic side view showing this example. In Figs. 1A and 1B, the reference numeral 4 designates FPCs; 5, a double-sided adhesive sheet having a base; 51, pressure-sensitive adhesive layers of the double-sided adhesive sheet 5; 6, a carrier board (fixing board); 71, mother board-fixing guide pins; 72, FPC-positioning guide pins; 71a, holes for inserting the mother board-fixing guide pins 71; 72a, holes for inserting the FPC-positioning guide pins 72; and 8, a carrier fixing table In Figs. 1A and 1B, the double-sided adhesive sheet 5 is stuck onto the whole or the nearly whole of one surface of the carrier board 6, and the FPCs 4 are stuck to a pressure-sensitive adhesive layer 51 of the double-sided adhesive sheet 5 at predetermined portions. More specifically, the double-sided adhesive sheet 5 is stuck onto one surface of the carrier board 6 through one pressure-sensitive adhesive layer 51 of the double-sided adhesive sheet 5, and the FPCs are stuck and fixed to the other pressure-sensitive adhesive layer 51 of the double-sided adhesive sheet 5 at predetermined portions by use of the FPC-positioning guide pins 72 and the holes 72a. Then, the carrier board 6 with the stuck FPCs 4 stuck thereon is fixed onto the carrier fixing table 8 by use of the mother board-fixing guide pins 71 and the holes 71a. Incidentally, the holes 71a for inserting the mother board-fixing guide pins 71 and the holes 72a for inserting the FPC-positioning guide pins 72 can be formed by means of punching or the like after the double-sided adhesive sheet 5 is stuck onto the carrier board 6.

As described above, in the invention, the FPCs can be fixed to the carrier board easily because an adhesive sheet (e.g., double-sided adhesive sheet 5 in Figs. 1A and 1B), which has a base, and a pressure-sensitive adhesive layer provided on at least one surface of the base, is used so that the FPCs put on predetermined portions of the pressure-sensitive adhesive layer surface of the adhesive sheet provided on the carrier board are stuck and fixed to the carrier board. Moreover, when each FPC equipped with electronic parts is to be removed after the electronic parts are mounted in the FPC, the FPC equipped with the electronic parts can be simply removed from the carrier board having the pressure-sensitive adhesive layer as its surface without the necessity of separating the adhesive sheet. Accordingly, the FPCs can be fixed to the carrier board and removed from the carrier board with excellent workability. The workability can be improved greatly, so that the production cost can be reduced.

In addition, when the whole lower surface of each FPC is fixed to the carrier board through the pressure-sensitive adhesive layer, each FPC can be firmly fixed to the carrier board. For this reason, in this case, there is little or no gap formed between each FPC and (the pressure-sensitive adhesive layer as the surface of) the carrier board. Hence, there is no positional displacement generated in each FPC when electronic parts are fixed to the FPC. Hence, electronic parts can be mounted in each FPC with high positional accuracy.

### (Carrier Board)

Although a board rigid enough to ensure flatness, such as an aluminum board, a glass board or an epoxy-based resin board can be used as the carrier board 6, the material and shape of the carrier board 6 are not limited at all but can be selected suitably in accordance with an apparatus (especially, automatic mounting apparatus) for mounting electronic parts in each FPC.

### (Adhesive Sheet)

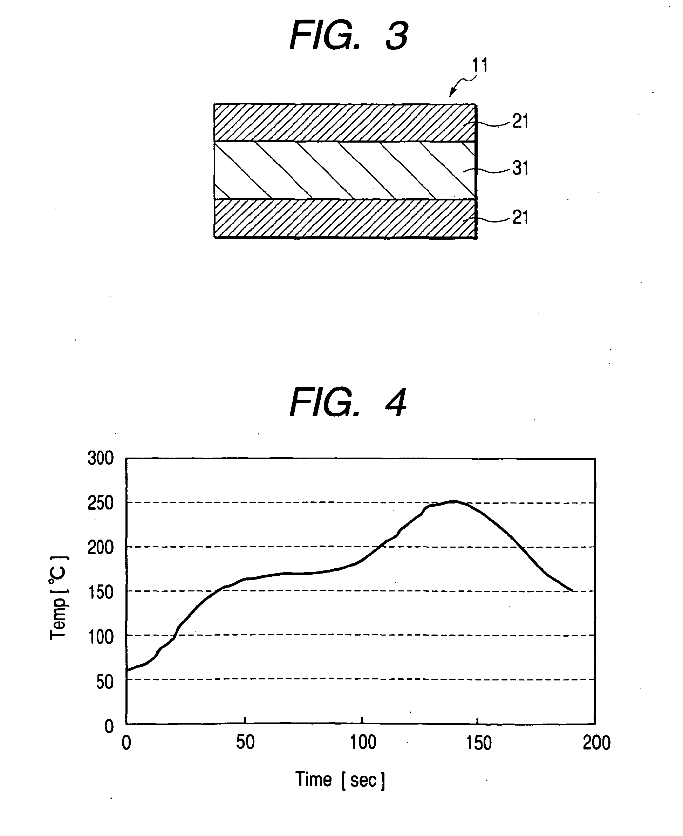

A single-sided adhesive sheet shown in Fig. 2 or a double-sided adhesive sheet shown in Fig. 3 can be used as the adhesive sheet (flexible printed circuit board-fixing adhesive sheet) which is used for fixing such flexible printed circuit boards onto the carrier board in order to mount electronic parts in a surface of each flexible printed circuit board. Fig. 2 is a schematic sectional view partially showing an example of the flexible printed circuit board-fixing adhesive sheet according to the invention. Fig. 3 is a schematic sectional view partially showing another example of the flexible printed circuit board-fixing adhesive sheet used according to the invention.

In Fig. 2, the flexible printed circuit board-fixing adhesive sheet 1 (hereinafter also referred to as "FPC-fixing adhesive sheet" or simply "adhesive sheet") has a pressure-sensitive adhesive layer 2, and a base 3. In the example shown in Fig. 2, the FPC-fixing adhesive sheet 1 has a structure in which the pressure-sensitive adhesive layer 2 is laminated on one surface (single surface) of the base 3. In Fig. 3, the FPC-fixing adhesive sheet 11 has pressure-sensitive adhesive layers 21, and a base 31. In the example shown in Fig. 3, the FPC-fixing adhesive sheet 11 has a structure in which the pressure-sensitive adhesive layers 21 are laminated on opposite surfaces of the base 31. As described above, an adhesive sheet formed to have a pressure-sensitive adhesive layer laminated on one or each of opposite surfaces of a base can be used as the FPC-fixing adhesive sheet (1, 11) used according to the invention.

In the FPC-fixing adhesive sheet (1, 11), each pressure-sensitive adhesive layer (2, 21) contains an acrylic-based polymer, and an aluminum-based crosslinker. The acrylic-based copolymer contains (meth)acrylic alkyl ester having an alkyl group with 4 to 14 carbon atoms [i.e., (meth)acrylic C₄₋₁₄-alkyl ester] as a main monomer component and contains a functional group in one molecule. Because the acrylic-based copolymer contains a functional group in one molecule, the acrylic-based copolymer can be crosslinked by the aluminum-based crosslinker by use of the functional group to thereby form the pressure-sensitive adhesive layer (2, 21). Accordingly, the pressure-sensitive adhesive layer (2, 21) of the FPC-fixing adhesive sheet (1, 11) can be made to exhibit excellent heat resistance, so that the pressure-sensitive adhesive layer (2, 21) is restrained or prevented from varying or deteriorating in accordance with the temperature of the pressure-sensitive adhesive layer (2, 21) when the FPC-fixing adhesive sheet (1, 11) is used in a predetermined temperature range (e.g., a temperature range of from 0°C to 300°C, both inclusive). Accordingly, even in the case where the FPC-fixing adhesive sheet (1, 11) is heated (e.g., IR-heated) in a heating process (e.g., an IR reflow process), the pressure-sensitive adhesive layer (2, 21) is neither softened nor hardened. Hence, excellent tackiness and releasability can be retained at the ordinary temperature. Specifically, each FPC does not drop out from the carrier board even after the heating process. Moreover, there is no pressure-sensitive adhesive component of the pressure-sensitive adhesive layer remaining on each FPC (i.e., there is no remaining adhesive) even in the case where the FPC is released.

### (Pressure-Sensitive Adhesive Layer)

The tackifier (pressure-sensitive adhesive agent) constituting the pressure-sensitive adhesive layer (2, 21) is an acrylic-based pressure-sensitive adhesive composition containing an acrylic-based copolymer as a base polymer, and an aluminum-based crosslinker as a crosslinking agent. The acrylic-based copolymer contains (meth)acrylic C₄₋₁₄-alkyl ester as a main monomer component and contains a functional group in one molecule. Additives or the like may be mixed with the pressure-sensitive adhesive agent as occasion demands. One kind of pressure-sensitive adhesive agent may be used singly or two or more kinds of pressure-sensitive adhesive agents may be used in combination.

### (Acrylic-based copolymer)

For example, the acrylic-based copolymer can be prepared by the following method (1) or (2). The method (1) is a method of copolymerizing (meth)acrylic C₄₋₁₄-alkyl ester as a main monomer component with a copolymerizable monomer containing a functional group (i.e., a functional group-containing copolymerizable monomer) as a monomer component copolymerizable to the (meth)acrylic C₄₋₁₄-alkyl ester (i.e., as a copolymerizable monomer component) and with another copolymerizable monomer provided as occasion demands. The method (2) is a method of making use of know chemical reaction to give a functional group to an acrylic-based polymer containing (meth)acrylic C₄₋₁₄-alkyl ester as a main monomer component and containing another copolymerizable monomer as a copolymerizable monomer component as occasion demands. In the invention, the acrylic-based copolymer can be preferably prepared by the method (1).

For example, the ratio of the amount of (meth)acrylic C₄₋₁₄-alkyl ester used as a main monomer component of the acrylic-based copolymer to the total amount of all monomer components can be selected to be not lower than 50 % by weight (in a range of from 50 % by weight to 100 % by weight). The ratio of the amount of (meth)acrylic C₄₋₁₄-alkyl ester to the total amount of all monomer components is preferably selected to be not lower than 80 % by weight, more preferably not lower than 90 % by weight. Particularly, the optimum ratio is not lower than 97 % by weight.

Examples of the functional group in the acrylic-based copolymer include a carboxyl group, a nitrogen atom-containing group (such as an amide group, an amino group, a cyano group, or an imide group), a hydroxyl group, an epoxy group, a mercapto group, and an isocyanate group. It is preferable from the point of view of reactivity to the aluminum-based crosslinker that a polar group such as a carboxyl group, an amide group, an amino group, or a cyano group (particularly a carboxyl group) is used as the functional group. One functional group may be used singly or a plurality of functional groups may be used in combination.

Specifically, the region of the alkyl group in (meth) acrylic C₄₋₁₄-alkyl ester is not particularly limited if the alkyl group has 4 to 14 carbon atoms. Examples of the alkyl group include a butyl group, an isobutyl group, an s-butyl group, a t-butyl group, a pentyl group, an isopentyl group, a neopentyl group, a hexyl group, a heptyl group, an octyl group, an isooctyl group, a 2-ethylhexyl group, a nonyl group, an isononyl group, a decyl group, an isodecyl group, an undecyl group, a dodecyl group (lauryl group), a tridecyl group, and a tetradecyl group (myristyl group). Specifically, examples of the (meth)acrylic C₄₋₁₄-alkyl ester include n-butyl (meth)acrylate, isobutyl (meth)acrylate, s-butyl (meth)acrylate, t-butyl (meth)acrylate, pentyl (meth)acrylate, neopentyl (meth)acrylate, hexyl (meth)acrylate, heptyl (meth)acrylate, octyl (meth)acrylate, isooctyl (meth)acrylate, 2-ethylhexyl (meth)acrylate, decyl (meth)acrylate, isodecyl (meth)acrylate, lauryl (meth)acrylate, and myristyl (meth)acrylate. Preferred examples of the (meth) acrylic C₄₋₁₄-alkyl ester include butyl (meth)acrylate, isooctyl (meth)acrylate, 2-ethylhexyl (meth)acrylate, and isononyl (meth)acrylate. One kind of (meth)acrylic C₄₋₁₄-alkyl ester may be used singly or two or more kinds of (meth)acrylic C₄₋₁₄-alkyl ester may be used in combination.

Examples of the functional group-containing copolymerizable monomer include a carboxyl group-containing copolymerizable monomer, a nitrogen atom-containing copolymerizable monomer, a hydroxyl group-containing copolymerizable monomer, an epoxy group-containing copolymerizable monomer, a mercapto group-containing copolymerizable monomer, and an isocyanate group-containing copolymerizable monomer. More specifically, examples of the functional group-containing copolymerizable monomer include: a carboxyl group-containing copolymerizable monomer such as acrylic acid, methacrylic acid, itaconic acid, maleic acid anhydride, crotonic acid, maleic acid, and fumaric acid; a nitrogen atom-containing copolymerizable monomer, e.g., an amide group-containing copolymerizable monomer such as (meth)acrylamide, N-vinylpyrolidone, and N,N-dimethyl(meth)acrylamide, an amino group-containing copolymerizable monomer such as (meth)acryloylmorpholine and aminoethyl (meth)acrylate, a cyano group-containing copolymerizable monomer such as (meth)acrylonitrile, or an imide group-containing copolymerizable monomer such as cyclohexylmaleimide and isopropylmaleimide; a hydroxyl group-containing copolymerizable monomer such as hydroxymethyl (meth)acrylate, 2-hydroxyethyl (meth)acrylate, 3-hydroxypropyl (meth) acrylate, and glyceryl dimethacrylate; an epoxy group-containing copolymerizable monomer such as glycidyl (meth)acrylate; and an isocyanate group-containing copolymerizable monomer such as 2-methacryloyloxyethyl isocyanate. Further, a mercapto group which is a terminal group in a chain transfer agent can be introduced as the functional group. Of these functional group-containing copolymerizable monomers, a carboxyl group-containing copolymerizable monomer can be used preferably in terms of reactivity to the aluminum-based crosslinker and general-purpose characteristic. Especially, acrylic acid or methacrylic acid is the most suitable.

When the functional group-containing copolymerizable monomer is used, the ratio of the amount of the functional group-containing copolymerizable monomer to the total amount of all monomer components is selected to be in a range of from 0.1 % by weight to 10 % by weight, preferably in a range of from 0.1 % by weight to 3 % by weight.

Another copolymerizable monomer than the (meth)acrylic C₄₋₁₄-alkyl ester and the functional group-containing copolymerizable monomer may be further contained as a monomer component as occasion demands. Examples of the copolymerizable monomer include: (meth)acrylic alkyl ester containing an alkyl group having 1 to 3 carbon atoms, such as methyl (meth)acrylate, ethyl (meth)acrylate, n-propyl (meth)acrylate, and isopropyl (meth)acrylate; (meth)acrylic alkyl ester containing an alkyl group having 15 to 20 carbon atoms, such as stearyl (meth)acrylate; vinyl esters such as vinyl acetate; styrene-based monomer such as styrene; and α-olefin-based monomer such as ethylene and propylene.

For preparing the acrylic-based copolymer, a mixture of the monomer components can be subjected to an ordinary polarization method such as an emulsion polymerization method or a solution polymerization method. Further, a general polymerization method such as a batch polymerization method, a continuous drip polymerization method or a split polymerization method may be used. A polymerization initiator, a chain transfer agent, etc., which are known commonly or publicly, may be used for the polymerization. A commonly or publicly known emulsifying agent may be used for the emulsion polymerization. Incidentally, the temperature for the polymerization is, for example, in a range of from 30°C to 80°C.

### (Aluminum-Based Crosslinker)

The aluminum-based crosslinker is an aluminum chelate crosslinker. One kind of aluminum-based crosslinker may be used singly or two or more kinds of aluminum-based crosslinkers may be used in combination.

An aluminum chelate compound constituted by aluminum or an aluminum-containing compound [such as aluminum (mono or di) alcoholate] and a chelating agent capable of acting on aluminum (atom) to form a chelate ring is used as the aluminum chelate crosslinker. Examples of the chelating agent include a β-dicarbonyl compound [e.g., β-diketones such as acetylacetone, 2,4-hexanedione, 2,4-heptanedione, 3,5-heptanedione, 2,4-octanedione, 3,5-octanedione, 2,4-nonanedione, 3,5-nonanedione, and 5-methyl-2,4-hexanedione; β-ketoesters (acetoacetic C₁₋₂₀-alkyl ester, etc.) such as methyl acetoacetate, ethyl acetoacetate, propyl acetoacetate, isopropyl acetoacetate, butyl acetoacetate, isobutyl acetoacetate, s-butyl acetoacetate, t-butyl acetoacetate, 2-ethylhexyl acetoacetate, and dodecyl acetoacetate; β-diesters such diethyl malonate], and a carbonyl compound having a hydroxyl group or an amino group in the β position (e.g., diacetone alcohol, diacetone amine, salicylaldehyde, methyl salicylate, or N-methylsalicylamide). A chelating agent may be used singly or a plurality of chelating agents may be used in combination.

More specifically, examples of the aluminum chelate' crosslinker include: aluminum tris(acylacetonate) such as aluminum tris(acetylacetonate), and aluminum tris(propionylacetonate); aluminum tris(acetoacetic alkyl ester) such as aluminum tris(ethylacetoacetate), aluminum tris(t-butylacetoacetate), etc.; aluminum [(mono or bis)(acetylacetonate)] [(bis or mono)(acetoacetic alkyl ester)] such as aluminum mono(acetylacetonate) bis(ethylacetoacetate), aluminum mono(acetylacetonate) bis(isobutylacetoacetate), aluminum mono(acetylacetonate) bis(2-ethylhexylacetoacetate), and aluminum mono(acetylacetonate) bis(dodecylacetoacetate); [(mono or bis)(acylacetonate)] aluminum [(di or mono)alcoholate] such as (acetylacetonate) aluminum diisopropylate, and bis (acetylacetonate) aluminum monoisopropylate; and [(mono or bis) (acetoacetic alkyl ester)] aluminum [(di or mono)alcoholate] such as (ethylacetoacetate) aluminum diisopropylate, and bis(ethylacetoacetate) aluminum monoisopropylate.

An aluminum chelate crosslinker is preferably used as the aluminum-based crosslinker. Especially, aluminum tris (acetylacetonate) or aluminum tris (ethylacetoacetate) is preferably used as the aluminum-based crosslinker.

In the invention, polyfunctional (meth)acrylate may be added in order to improve the retaining characteristic of the pressure-sensitive adhesive agent. Examples of the polyfunctional (meth)acrylate include trimethylolpropane tri(meth)acrylate, pentaerythritol tetra(meth)acrylate, ethylene glycol di(meth)acrylate, and 1,6-hexanediol di(meth)acrylate.

Incidentally, when particularly high heat resistance is required of the pressure-sensitive adhesive agent, a polymer curable by irradiation with ultraviolet rays is preferably used as the pressure-sensitive adhesive agent. Various kinds of known additives such as a tackifier, a plasticizer, a softener, a filler, a colorant (e.g., pigment and dye), an age resistor, and an anti-oxidant may be added as optional components to the pressure-sensitive adhesive agent. Examples of the tackifier resin include: a petroleum-based resin such as an aliphatic petroleum resin, an aromatic petroleum resin, and an alicyclic petroleum resin (alicyclic saturated hydrocarbon resin) obtained by hydrogenation of an aromatic petroleum resin; a rosin-based resin (such as rosin and hydrogenated rosin ester); a terpenic-based resin (such as a terpene resin, an aromatic modified terpene resin, a hydrogenated terpene resin, and a terpene phenol resin); a styrene-based resin; and a coumarone-indene resin.

The thickness of the pressure-sensitive adhesive layer (2, 21) is not particularly limited. For example, the thickness can be selected to be in a range of from about 10 µm to about 200 µm, preferably in a range of from about 20 µm to about 100 µm.

### (Base)

The material of the base (3, 31) in the adhesive sheet (1, 11) is not particularly limited. A plastic film of polyester such as polyethylene terephthalate, polybutylene terephthalate or polyethylene naphthalate or of plastics such as polyphenylene sulfide, polyether-sulfone, polyether-imide, polyether-ether-ketone, polyimide or polyamide-imide can be preferably used as the base (3, 31). One kind of base material may be used singly or two or more kinds of base materials may be used in combination.

In a process for mounting electronic parts, the FPCs are generally exposed to a very high temperature for a short time because solder needs to be melted. For example, various heating conditions are used in infrared heating (IR heating) but a typical example is the heating condition that a peak temperature of about 260°C is retained as a maximum temperature and the retention time of the peak temperature is about 20 seconds. Accordingly, of these plastic films, a film having heat resistance is preferably used as the base (3, 31). For example, the temperature at which the heat-resistant film can be used continuously may be preferably not lower than 100°C (e.g., in a range of from 100°C to 350°C), more preferably not lower than 120°C (e.g., in a range of from 120°C to 300°C), further preferably not lower than 150°C (e.g., in a range of from 150°C to 280°C).

The base (3, 31) may be modified by surface treatment in order to obtain anchoring characteristic of the pressure-sensitive adhesive agent. The surface treatment is not particularly limited. For example, any one of acid treatment, corona discharge treatment, and plasma treatment, primer treatment may be used singly or two or more of these treatments may be used in combination in accordance with the kind of the pressure-sensitive adhesive agent, the kind of the base, and so on.

The thickness of the base (3, 31) is not particularly limited but can be selected suitably in accordance with the purpose of use. For example, the thickness is generally selected to be in a range of from 12 µm to 200 µm (preferably in a range of from 16 µm to 75 µm).

The adhesive sheet used according to the invention can be produced as follows. An acrylic-based copolymer containing (meth)acrylic alkyl ester having an alkyl group with 4 to 14 carbon atoms [i.e., (meth) acrylic C₄₋₁₄-alkyl ester] as a main monomer component and containing a functional group in one molecule is mixed with an aluminum-based crosslinker to prepare a tackifier (pressure-sensitive adhesive agent). A pressure-sensitive adhesive composition containing the pressure-sensitive adhesive agent is applied on at least one surface (one or each of opposite surfaces) of a base and crosslinked by heating or the like to thereby form a pressure-sensitive adhesive layer. In this manner, the adhesive sheet can be produced. Incidentally, the composition may be irradiated with electromagnetic wave such as ultraviolet rays in accordance with necessity. A release liner may be applied on the pressure-sensitive adhesive layer as occasion demands. Accordingly, the adhesive sheet (pressure-sensitive adhesive sheet) used according to the invention may be a double-sided adhesive sheet having pressure-sensitive adhesive layers on opposite surfaces of the base or may be a single-sided adhesive sheet having a pressure-sensitive adhesive layer on one of the opposite surfaces of the base.

Preferably, the adhesive sheet used according to the invention is provided as a double-sided adhesive sheet. Incidentally, when the adhesive sheet is provided as a double-sided adhesive sheet, pressure-sensitive adhesive agents (adhesive agents) in the pressure-sensitive adhesive layers laminated on opposite surfaces of the base may be different from each other or may be identical to each other.

For example, as shown in Figs. 1A and 1B, the adhesive sheet used according to the invention is used as an adhesive sheet for bonding and fixing FPCs (flexible printed circuit boards) to a carrier board. Incidentally, in Figs. 1A and 1B, a double-sided adhesive sheet 5 containing a base is provided between a carrier board 6 and each FPC 4 so that each FPC 4 is bonded to the carrier board 6. That is, the FPCs 4 are bonded to the carrier board 6 through the double-sided adhesive sheet 5. Although Figs. 1A and 1B particularly show the case where the base-containing double-sided adhesive sheet 5 is stuck to the whole of one surface of the carrier board 6, the invention may be also applied to the case where the base-containing double-sided adhesive sheet 5 is stuck to only predetermined places (e.g., FPC setting places and their peripheral places or part of FPC setting places) of one surface of the carrier board 6.

In the invention, the adhesive sheet may be a base-containing single-sided adhesive sheet (adhesive tape). In this case, the base side surface of the adhesive tape may be stuck to the whole or a predetermined place of the carrier board by use of an adhesive agent so that the carrier board can be formed to have the pressure-sensitive adhesive layer of the adhesive tape on its surface. In this manner, each FPC can be stuck and fixed to the surface of the pressure-sensitive adhesive layer.

In the invention, the tensile strength of the adhesive sheet is preferably selected to be not smaller than 5 N/15 mm (e.g., in a range of from 5 N/15 mm to 150 N/15 mm), more preferably not smaller than 8 N/15 mm (e.g., in a range of from 8 N/15 mm to 50 N/15 mm) so that the adhesive sheet itself can be released from the carrier board having the adhesive sheet stuck thereto, easily without breaking. It is particularly preferable that the tensile strength of the adhesive sheet is kept not smaller than 5 N/15 mm (especially not smaller than 8 N/15 mm) even after electronic parts are mounted. When the tensile strength of the adhesive sheet is kept in the range after electronic parts are mounted, the carrier board can be recycled because the adhesive sheet can be released from the carrier board easily without breaking.

In the invention, the adhesion of the pressure-sensitive adhesive layer to each FPC is preferably selected to be smaller than 7.5 N/20 mm (e.g., in a range of from 0.1 N/20 mm to 7.3 N/20 mm), especially in a range of from 0.3 N/20 mm to 2.0 N/20 mm so that each FPC having electronic parts mounted therein can be released from the pressure-sensitive adhesive layer (i.e., FPC pick-up characteristic can be improved) after the electronic parts are mounted in the FPC. When a double-sided adhesive sheet is used as shown in Figs. 1A and 1B, the adhesion of the adhesive sheet to the carrier board can be selected to be in a range equal to the range of the adhesion of the adhesive sheet to each FPC. In the invention, the adhesion of the adhesive sheet can be adjusted suitably by selection of the kind of the pressure-sensitive adhesive agent, the kind of additive contained in the pressure-sensitive adhesive agent, the mixture ratio thereof, and so on.

Incidentally, the guide pins (71, 72), the carrier fixing table 8, etc. are not particularly limited but can be selected suitably in accordance with a machine for mounting electronic parts in each FPC (especially, an automatic mounting machine).

The adhesive sheet used according to the invention can be preferably used as an adhesive sheet (such as an adhesive tape) stuck to each FPC (flexible printed circuit board) or each FPC-reinforcing board and punched into a suitable shape as occasion demands. In the flexible printed circuit board-fixing adhesive sheet used according to the invention, the pressure-sensitive adhesive layer is made of an acrylic-based pressure-sensitive adhesive composition containing an acrylic-based copolymer, and an aluminum-based crosslinker. The acrylic-based copolymer contains (meth)acrylic alkyl ester having an alkyl group with 4 to 14 carbon atoms as a main monomer component and contains a functional group in one molecule. Accordingly, the tackiness of the pressure-sensitive adhesive layer little varies after a heating process (such as an IR heating process), so that there is little or no deformation/deterioration. Moreover, when a heat-resistant film is used as the base, the base can be restrained or prevented from being deformed or deteriorated even after the heating process (such as an IR heating process). Accordingly, the tackiness (adhesion) of the pressure-sensitive adhesive layer is kept good even in the case where the pressure-sensitive adhesive layer is heated. Hence, each FPC is firmly held on the carrier board, so that each FPC is not displaced after heating. Accordingly, electronic parts can be mounted in each FPC with high positional accuracy. Moreover, the releasability of the pressure-sensitive adhesive layer is kept good even after heating, so that dropout of each FPC or 0 remaining on each FPC is not generated.

When the adhesive sheet is provided as a double-sided' adhesive sheet, the adhesive sheet itself can be released from the carrier board easily without breaking after electronic parts are mounted in each FPC. Hence, release/removal of the adhesive sheet can be performed well after the adhesive sheet is used.

Accordingly, the adhesive sheet used according to the invention is very useful as an FPC-fixing adhesive sheet.

Incidentally, electronic parts mounted in each FPC are not particularly limited. Examples of the electronic parts include ICs, capacitors, connectors, resistors, and LEDs (light-emitting diodes).

### Examples

The invention will be described below more specifically in connection with the following examples but is not limited to the following examples. Incidentally, the term "parts" shown below means "parts by weight".

### (Example 1)

In 210 parts of toluene, 97 parts of 2-ethylhexyl acrylate and 3 parts of acrylic acid were solution-polymerized while stirred at a temperature of from 60°C to 80°C under the coexistence of 0.3 parts of 2,2'-azobisisobutyronitrile and under an atmosphere of nitrogen substitution to thereby prepare a solution having a viscosity of about 110 poise and a rate of polymerization of 99.4 % and containing 32 % by weight of a solid content. Into 100 parts (solid content) of the solution, 2 parts of an age resistor (tradename "IRGANOX 1010", made by Ciba-Geigy) and 20 parts of isopropyl alcohol were added to thereby prepare a crosslinker-free pressure-sensitive adhesive agent solution (referred to as "crosslinker-free pressure-sensitive adhesive agent (B1)").

Into 100 parts of the polymer solid content of the crosslinker-free pressure-sensitive adhesive agent (B1), 1 part of aluminum trisacetylacetonate (tradename "ALUMICHELATE AW", made by Kawaken Fine Chemicals Co., Ltd.) was added and mixed to thereby prepare a crosslinker-containing pressure-sensitive adhesive agent (referred to as "crosslinker-containing pressure-sensitive adhesive agent (A1)").

Into 100 parts of the polymer solid content of the crosslinker-free pressure-sensitive adhesive agent (B1), 0.5 parts of aluminum trisacetylacetonate (tradename "ALUMICHELATE AW", made by Kawaken Fine Chemicals Co., Ltd.) were added and mixed to prepare a crosslinker-containing pressure-sensitive adhesive agent (referred to as "crosslinker-containing pressure-sensitive adhesive agent (A2)").

The crosslinker-containing pressure-sensitive adhesive agent (A1) was applied onto one surface of a polyphenylene sulfide film (tradename "TORELINA 3040", made by Toray Industries, Inc.; 25 µm thick) to obtain a thickness of 25 µm after drying. Then, the adhesive agent (A1) was dried in a hot air dryer at 120°C for 3 minutes to thereby form an FPC-side pressure-sensitive adhesive layer. Further, a separator was stuck to a surface of the FPC-side pressure-sensitive adhesive layer. Then, the crosslinker-containing pressure-sensitive adhesive agent (A2) was applied onto the other surface of the polyphenylene sulfide film (tradename "TORELINA 3040", made by Toray Industries, Inc.; 25 µm thick) in the same manner as described above to obtain a thickness of 50 µm after drying. The adhesive agent (A2) was dried in the same manner as described above to thereby form a carrier support board-side pressure-sensitive adhesive layer. Thus, a double-sided adhesive sheet was produced.

### (Example 2)

Into 100 parts of the polymer solid content of the crosslinker-free pressure-sensitive adhesive agent (B1) prepared in Example 1, 3 parts of aluminum trisacetylacetonate (tradename "ALUMICHELATE AW", made by Kawaken Fine Chemicals Co., Ltd.) were added and mixed to thereby prepare a crosslinker-containing pressure-sensitive adhesive agent (referred to as "crosslinker-containing pressure-sensitive adhesive agent (A3)").

A double-sided adhesive sheet was produced in the same manner as in Example 1 except that the crosslinker-containing pressure-sensitive adhesive agent (A3) was used as a pressure-sensitive adhesive agent of the FPC-side pressure-sensitive adhesive layer (25 µm thick). Hence, the carrier support board-side pressure-sensitive adhesive layer (50 µm thick) of the double-sided adhesive sheet was a pressure-sensitive adhesive layer made of the crosslinker-containing pressure-sensitive adhesive agent (A2) in the same manner as in Example 1.

### (Example 3)

Into 100 parts of the polymer solid content of the crosslinker-free pressure-sensitive adhesive agent (B1) prepared in Example 1, 5 parts of aluminum trisacetylacetonate (tradename "ALUMICHELATE AW", made by Kawaken Fine Chemicals Co., Ltd.) were added and mixed to thereby prepare a crosslinker-containing pressure-sensitive adhesive agent (referred to as "crosslinker-containing pressure-sensitive adhesive agent (A4)").

A double-sided adhesive sheet was produced in the same manner as in Example 1 except that the crosslinker-containing pressure-sensitive adhesive agent (A4) was used as a pressure-sensitive adhesive agent of the FPC-side pressure-sensitive adhesive layer (25 µm thick). Hence, the carrier support board-side pressure-sensitive adhesive layer (50 µm thick) of the double-sided adhesive sheet was a pressure-sensitive adhesive layer made of the crosslinker-containing pressure-sensitive adhesive agent (A2) in the same manner as in Example 1.

### (Comparative Example 1)

Into 100 parts of the polymer solid content of the crosslinker-free pressure-sensitive adhesive agent (B1) prepared in Example 1, 1.5 parts of an epoxy-based crosslinker (tradename "TETRAD C", made by Mitsubishi Gas Chemical Co., Inc.) were added and mixed to thereby prepare a crosslinker-containing pressure-sensitive adhesive agent (referred to as "crosslinker-containing pressure-sensitive adhesive agent (A5)").

Into 100 parts of the polymer solid content of the crosslinker-free pressure-sensitive adhesive agent (B1) prepared in Example 1, 0.1 parts of an epoxy-based crosslinker (tradename "TETRAD C", made by Mitsubishi Gas Chemical Co., Inc.) were added and mixed to thereby prepare a crosslinker-containing pressure-sensitive adhesive agent (referred to as "crosslinker-containing pressure-sensitive adhesive agent (A6)").

A double-sided adhesive sheet was produced in the same manner as in Example 1 except that the crosslinker-containing pressure-sensitive adhesive agent (A5) was used as a pressure-sensitive adhesive agent of the FPC-side pressure-sensitive adhesive layer (25 µm thick) while the crosslinker-containing pressure-sensitive adhesive agent (A6) was used as a pressure-sensitive adhesive agent of the carrier support board-side pressure-sensitive adhesive layer (50 µm thick).

### (Comparative Example 2)

Into 100 parts of the polymer solid content of the crosslinker-free pressure-sensitive adhesive agent (B1) prepared in Example 1, 6 parts of an isocyanate-based crosslinker (tradename "CORONATE L", made by Nippon Polyurethane Industry Co., Ltd.) and 0.05 parts of a tin-based catalyst were added and mixed to thereby prepare a crosslinker-containing pressure-sensitive adhesive agent (referred to as "crosslinker-containing pressure-sensitive adhesive agent (A7)").

Into 100 parts of the polymer solid content of the crosslinker-free pressure-sensitive adhesive agent (B1) prepared in Example 1, 2 parts of an isocyanate-based crosslinker (tradename "CORONATE L", made by Nippon Polyurethane Industry Co., Ltd.) and 0.05 parts of a tin-based catalyst were added and mixed to thereby prepare a crosslinker-containing pressure-sensitive adhesive agent (referred to as "crosslinker-containing pressure-sensitive adhesive agent (A8)").

A double-sided adhesive sheet was produced in the same manner as in Example 1 except that the crosslinker-containing pressure-sensitive adhesive agent (A7) was used as a pressure-sensitive adhesive agent of the FPC-side pressure-sensitive adhesive layer (25 µm thick) while the crosslinker-containing pressure-sensitive adhesive agent (A8) was used as a pressure-sensitive adhesive agent of the carrier support board-side pressure-sensitive adhesive layer (50 µm thick).

### (Evaluation)

The adhesive sheets produced in Examples 1 to 3 and Comparative Examples 1 and 2 as to 180° peel adhesion, IR reflow retention, FPC pick-up characteristic after IR heating and adhesive sheet releasability after IR heating were measured and evaluated by the following method. Results of the measurement and evaluation were as shown in Table 1.

### (180° Peel Adhesion)

After a 25 µm-thick polyimide film ("KAPTON 100H" made by Du Pont-Toray Co., Ltd. and used generally as a base of an FPC) was stuck to one surface (carrier support board-side pressure-sensitive adhesive layer side surface) of each of the adhesive sheets produced in Examples 1 to 3 and Comparative Examples 1 and 2, a separator was released to thereby produce an adhesive tape 20 mm wide and 100 mm long. The adhesive tape was stuck, as an adherend, to each of a polyimide film the same as described above and an aluminum board by a forward rotation and a backward rotation of a 2 kg roller. The 180° peel strength (N/20 mm) of each of the adhesive tapes at a speed of 300 mm/min was measured with a tensile tester in the case where the adhesive tape was aged in the condition of 23°C and 50%RH for 30 minutes ("Initial 23°C"), in the case where the adhesive tape was aged in the condition of 200°C for 30 minutes ("Initial 200°C") [when the adherend was only the polyimide film], and in the case where the adhesive tape was aged in the condition of 23°C and 50%RH for 30 minutes after IR-heated under the condition of the IR reflow temperature shown in Fig. 4 ("After IR heating"). Incidentally, respective results of the evaluation were shown in the "23°C", "200°C" and "After IR reflow" lines in the "FPC side to polyimide film" and "support board side to aluminum" lines in the "180° peel adhesion" line in Table 1.

### (IR Reflow Retention)

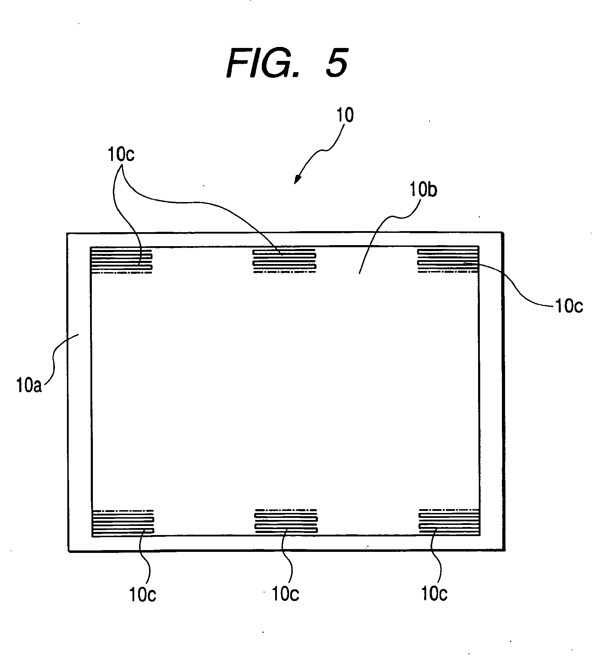

As shown in Fig. 5, a polyimide-copper foil laminate of PI (polyimide)/copper foil/PI (size: 130 mm X 180 mm X 0.1 mm) was stuck to an aluminum board (size: 150 mm X 200 mm X 2 mm) through each of the adhesive sheets produced in Examples 1 to 3 and Comparative Examples 1 and 2. Thus, the laminate of PI/copper foil/PI fixed to the aluminum board (support board) was used as an FPC sample. Specifically, the number of fixing positions by each of the adhesive sheets produced in Examples 1 to 3 and Comparative Examples 1 and 2 was two at opposite ends of each long side and one at the central portion of each long side, that is, six in total (three each long side), and the size of the double-sided adhesive sheet provided in each fixing position was 10 mm X 30 mm. In Fig. 5, the FPC sample 10 has a support board (aluminum board) 10a, a polyimide-copper foil laminate 10b, and adhesive sheets 10c.

The FPC sample was IR-heated under the condition of the IR reflow temperature shown in Fig. 4. The sticking state of the FPC sample after IR heating was observed by eyes. Incidentally, results of the evaluation were shown in the "IR reflow retention" line in Table 1.

### (FPC Pick-Up Characteristic after IR Heating)

An aluminum carrier board was used as the carrier board. As shown in Figs. 1A and 1B, six FPCs were positioned relative to one carrier board. Then, the FPCs were put on the pressure-sensitive adhesive layer formed on a surface of the carrier board and pushed by hand so as to be bonded and fixed to the carrier board. Then, the FPCs were IR-heated Releasability of the FPCs and stress imposed on the FPCs were examined sensually (by the sense of touch) to evaluate FPC pick-up characteristic in the case where the FPCs were peeled from the adhesive sheets just after IR heating and in the case where the FPCs were peeled from the adhesive sheets after the FPCs were cooled to the room temperature. Incidentally, respective results of the evaluation were shown in the "FPC pick-up characteristic after IR heating" line in Table 1.

### (Adhesive Sheet Releasability after IR Heating)

After the FPC pick-up characteristic after IR heating was measured, releasability of the adhesive sheets from the aluminum carrier board (easiness to release) was examined sensually (by the sense of touch) for evaluation of adhesive sheet releasability. Incidentally, respective results of the evaluation were shown in the "adhesive sheet releasability after IR heating" line in Table 1.

**(Table 1)**

| | | | Example | | | Comparative Example | |
|---|---|---|---|---|---|---|---|
| | | | 1 | 2 | 3 | 1 | 2 |
| 180° peel adhesion (N/20 mm) | FPC side to polyimide film | 23°C | 2.8 | 1.5 | 0.7 | 1.5 | 3.5 |
| | | 200°C | 0.5 | 0.3 | 0.2 | 0.05 | 1.5 (*1) |
| | | After IR reflow | 5.2 | 3.2 | 1.5 | 2.9 | 7.2 (*1) |
| | Support board side to aluminum | 23°C | 4.5 | 4.5 | 4.5 | 5.1 | 5.3 |
| | | After IR reflow | 7.3 | 7.3 | 7.3 | 7.5 | 6.6 (*1) |
| IR reflow retention | | | (*2) | (*2) | (*2) | (*3) | |
| FPC pick-up characteristic after IR heating | | | good | good | good | - | (*4) |
| Adhesive sheet releasability after IR heating | | | good | good | good | good | (*5) |

| | | | | | | | |
|---|---|---|---|---|---|---|---|
| (*1): cohesive failure | | | | | | | |
| (*2): FPC did not drop out. | | | | | | | |
| (*3): FPC dropped out. | | | | | | | |
| (*4): Adhesive remained on the FPC side. | | | | | | | |
| (*5): Adhesive remained on the support side. | | | | | | | |

It was apparent from Table 1 that the adhesive sheets produced in Examples 1 to 3 were relatively low in reduction of adhesion under a high temperature of 200°C so that there was no cohesive failure in the adhesive sheets. Moreover, the pressure-sensitive adhesive layers did not deteriorate even in the case where IR heating was performed, so that the adhesive sheets were good in IR reflow retention of the FPCs. Moreover, the adhesive sheets were excellent in FPC pick-up characteristic after IR heating. In addition, the adhesive sheets were good in adhesive sheet releasability after IR heating. Consequently, the adhesive sheets produced in Examples 1 to 3 are good in adhesion, IR reflow retention, FPC pick-up characteristic and adhesive sheet releasability which are very important as adhesive tapes for fixing FPCs in order to mount electronic parts in the FPCs.

On the other hand, in Comparative Example 1, reduction of adhesion at a high temperature was conspicuous and IR reflow retention was low, so that each FPC dropped out from the support board in the IR reflow retention test. In Comparative Example 2, a cohesive failure occurred under a high temperature and adhesive remained on each FPC or on the support board.

In the flexible printed circuit board-fixing adhesive sheet according to the invention, the pressure-sensitive adhesive layer contains a specific acrylic-based copolymer, and an aluminum-based crosslinker. Hence, the flexible printed circuit board can be stuck to and released from the carrier board easily. Even in the case where the pressure-sensitive adhesive layer is heated when electronic parts are mounted in each flexible printed circuit board, the pressure-sensitive adhesive layer can be restrained or prevented from being deformed or deteriorated. Hence, each FPC can be attached/detached to/from the carrier board with excellent workability when electronic parts are mounted in the FPC. Moreover, the FPC can be prevented from dropping out from the pressure-sensitive adhesive layer even after the heating process. Moreover, there is no pressure-sensitive adhesive component remaining on the FPC after release. Moreover, the adhesive sheet itself can be released from the carrier board easily without breaking. Accordingly, electronic parts can be mounted in each FPC with high accuracy.

## Claims

1. Use of an adhesive sheet, said adhesive sheet comprising:
a base; and
a pressure-sensitive adhesive layer formed on at least one surface of said base and including an acrylic-based copolymer, and an aluminum-based chelate crosslinker which includes an aluminum chelate compound constituted by aluminum and a chelating agent capable of acting on aluminum to form a chelate ring, said acrylic-based copolymer containing (meth)acrylic alkyl ester having an alkyl group with 4 to 14 carbon atoms as a main monomer component and containing a functional group in one molecule, said functional group being derived from a functional group contained in a functional group-containing copolymerizable monomer as a copolymerizable monomer component, wherein a ratio of an amount of said functional group-containing copolymerizable monomer to a total amount of monomer components is selected to be in a range of from 0.1 % by weight to 10 % by weight,
for fixing a flexible printed circuit board to a carrier board when electronic parts are mounted on a surface of said flexible printed circuit board.

2. The use according to Claim 1, wherein said base is a heat-resistant film allowed to be used continuously at a temperature of not lower than 100°C.

3. A method of mounting electronic parts in a flexible printed circuit board, comprising the steps of:
fixing a flexible printed circuit board to a carrier board by an adhesive sheet defined in Claim 1; and
mounting electronic parts in a surface of said flexible printed circuit board.

## Patentansprüche

1. Verwendung einer Klebefolie, wobei die Klebefolie umfasst:
Ein Trägermaterial; und
eine Haftkleberschicht, die auf wenigstens einer Oberfläche des besagten Trägermaterials gebildet ist, und ein Acryl-basiertes Copolymer und einen Aluminiumbasierten Chelatvernetzer beinhaltet, der eine Aluminium-Chelat-Verbindung beinhaltet, die aus Aluminium und einem Chelatbildner gebildet ist, der im Stande ist auf das Aluminium unter Bildung eines Chelatrings einzuwirken, wobei das besagte Acryl-basierte Copolymer einen (Meth)Acrylsäurealkylester enthält, der eine Alkylgruppe mit 4 bis 14 Kohlenstoffatomen als einen Hauptmonomerbestandteil hat und eine funktionelle Gruppe in einem Molekül enthält, wobei die funktionelle Gruppe von einer funktionellen Gruppe abgeleitet ist, die in einem eine funktionelle Gruppe enthaltenden copolymerisierbaren Monomer als ein copolymerisierbarer Monomerbestandteil enthalten ist, wobei das Verhältnis der Menge des besagten eine funktionelle Gruppe enthaltenden copolymerisierbaren Monomers zur Gesamtmenge der Monomerbestandteile ausgewählt ist, um in einem Bereich von 0,1 Gew.-% bis 10 Gew.-% zu liegen,
zum Befestigen einer flexiblen Leiterplatte auf einer Trägerplatte (carrier board), wenn elektronische Teile auf der Oberfläche der besagten flexiblen Leiterplatte montiert werden.

2. Verwendung gemäß Anspruch 1, worin das besagte Trägermaterial ein hitzebeständiger Film ist, der kontinuierlich bei einer Temperatur von nicht weniger als 100°C verwendet werden kann.

3. Verfahren zum Montieren elektronischer Teile auf einer flexiblen Leiterplatte, umfassend die Schritte:
Fixieren einer flexiblen Leiterplatte auf einer Trägerplatte (carrier board) mittels einer in Anspruch 1 definierten Klebefolie; und
Montieren elektronischer Teile auf einer Oberfläche der besagten flexiblen Leiterplatte.

## Revendications

1. Utilisation d'une feuille adhésive, ladite feuille adhésive comprenant :
une base ; et
une couche adhésive autocollante formée sur au moins une surface de ladite base et comprenant un copolymère à base d'acrylique, et un agent de réticulation chélate à base d'aluminium qui comprend un composé chélate d'aluminium constitué par de l'aluminium et un agent chélatant capable d'agir sur l'aluminium pour former un cycle chélate, ledit copolymère à base d'acrylique contenant un ester d'alkyle (méth)acrylique comportant un groupe alkyle ayant 4 à 14 atomes de carbone en tant que composant monomère principal et contenant un groupe fonctionnel dans une molécule, ledit groupe fonctionnel étant dérivé d'un groupe fonctionnel contenu dans un monomère copolymérisable contenant un groupe fonctionnel en tant que composant monomère copolymérisable, dans laquelle un rapport d'une quantité dudit monomère copolymérisable contenant un groupe fonctionnel sur une quantité totale de composants monomères est choisi pour être dans une gamme allant de 0,1 % en poids à 10 % en poids,
pour fixer une carte de circuit imprimé flexible à une carte de support lorsque des composants électroniques sont montés sur une surface de ladite carte de circuit imprimé flexible.

2. Utilisation selon la revendication 1, dans laquelle ladite base est un film résistant à la chaleur pouvant être utilisé en continu à une température non inférieure à 100 °C.

3. Procédé de montage de composants électroniques dans une carte de circuit imprimé flexible, comprenant les étapes consistant à :
fixer une carte de circuit imprimé flexible sur une carte support par une feuille adhésive définie dans la revendication 1 ; et
monter les composants électroniques dans une surface de ladite carte de circuit imprimé flexible.
